Europäisches Patentamt

**European Patent Office**

**Office européen des brevets**

(11) Numéro de publication: **0 190 073 B1**

(12) **FASCICULE DE BREVET EUROPEEN**

(45) Date de publication de fascicule du brevet: **19.08.92** (51) Int. Cl.⁵: **H03F 1/32**

(21) Numéro de dépôt: **86400103.7**

(22) Date de dépôt: **20.01.86**

(54) **Amplificateur en classe AB et son correcteur de distorsion.**

(30) Priorité: **25.01.85 FR 8501081**

(43) Date de publication de la demande:
**06.08.86 Bulletin 86/32**

(45) Mention de la délivrance du brevet:
**19.08.92 Bulletin 92/34**

(84) Etats contractants désignés:
**CH DE GB IT LI NL**

(56) Documents cités:
**FR-A- 2 044 249**
**US-A- 4 152 665**

(73) Titulaire: **THOMSON-CSF**
**51, Esplanade du Général de Gaulle**
**F-92800 Puteaux(FR)**

(72) Inventeur: **Michel, Jean**
**THOMSON-CSF SCPI 19, avenue de Messine**
**F-75008 Paris(FR)**

(74) Mandataire: **Courtellemont, Alain et al**
**THOMSON-CSF SCPI**
**F-92045 PARIS LA DEFENSE CEDEX 67(FR)**

## Description

La présente invention se rapporte à un amplificateur en classe AB et au correcteur de distorsion qui lui est associé dans le but d'obtenir une amplification linéaire et, en particulier, une amplification linéaire, de puissance, pour signaux de télévision.

Il est connu que, par exemple, l'amplification d'une onde modulée par un spectre asymétrique dans la voie image et, a fortiori, l'amplification commune du son et de l'image dans une même voie, nécessitent des amplificateurs linéaires. Il semble donc nécessaire d'utiliser des amplificateurs en classe A ou en classe B, mais des considérations de rendement et de faisabilité empêchent de réaliser de cette façon une amplification linéaire de puissance. Cette amplification est donc réalisée en classe AB.

L'amplification linéaire de puissance, telle qu'elle était pratiquée jusqu'alors, présente une mauvaise linéarité pour les faibles signaux; ceci est dû, comme il sera montré plus loin à un préjugé bien établi.

Le but de la présente invention est de permettre une amplification linéaire de qualité en classe AB; ceci est obtenu en allant contre le préjugé ci-avant mentionné.

Selon l'invention un amplificateur en classe AB et son correcteur de distorsion, le correcteur comportant un correcteur de creux, sont caractérisés en ce que le courant de repos de l'amplificateur est choisi de manière que la caractéristique Vs = f(Ve) de l'amplificateur (où Ve et Vs sont respectivement les tensions d'entrée et de sortie de l'amplificateur) soit à dérivée à variation monotone pour les faibles niveaux, et en ce que la caractéristique Vs' = f(Ve') du correcteur de creux (où Ve' et Vs' sont respectivement les tensions d'entrée et de sortie du correcteur de creux) présente une concavité tournée vers les valeurs croissantes, au moins en valeur absolue, de Vs'.

Le brevet US-A 4 152 665 concerne un dispositif pour améliorer la linéarité des circuits de réception FM. Cependant cela suppose que l'on connait déjà le type de distorsions à corriger.

La présente invention sera mieux comprise et d'autres caractéristiques apparaîtront à l'aide de la description ci-après et des figures s'y rapportant qui représentent :

- la figure 1, une première représentation graphique relative à l'amplification en classe AB,
- la figure 2, le schéma de principe d'un amplificateur en classe AB
- les figures 3 à 5 des graphiques relatifs à l'amplificateur de la figure 2,
- la figure 6, une chaîne de transmission avec amplification en classe AB
- les figures 7 et 9, des circuits pour la correction d'amplificateurs en classe AB,
- les figures 8 et 10 des graphiques relatifs respectivement aux circuits selon les figures 7 et 9.

L'étude ci-après est faite dans le cadre de l'amplification simultanée de signaux de télévision son et image, transmis sur une même voie; mais les conclusions auxquelles elle aboutit, sont valables quel que soit le type de signal à amplifier linéairement en classe AB.

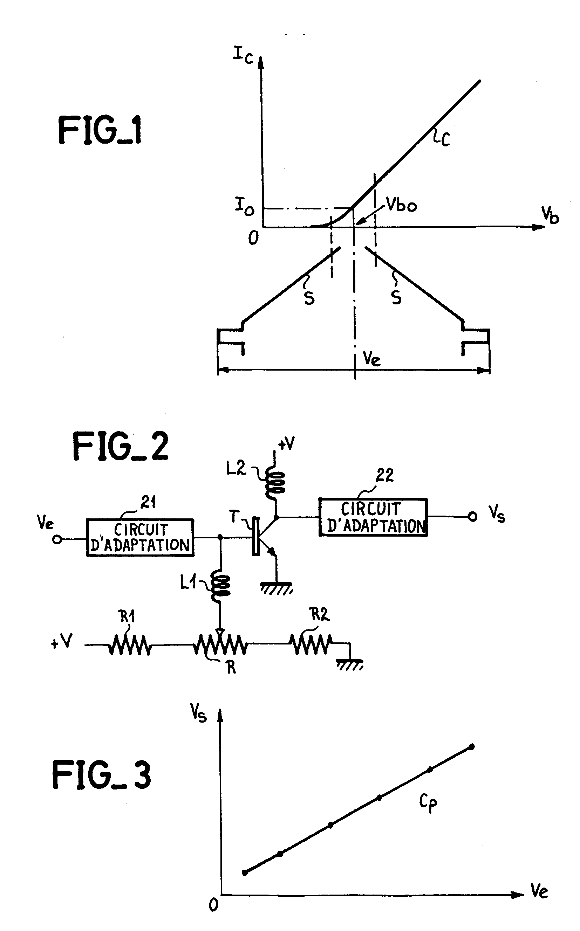

La figure 1 montre une caractéristique Ic = f(Vb) d'un amplificateur dans lequel Ic désigne le courant collecteur d'un transistor et Vb la tension base-émetteur de ce transistor. Sur cette figure a été indiqué le courant de repos Io, fonction d'une tension de polarisation Vbo, caractéristique d'un fonctionnement en classe AB de l'amplificateur considéré ; en cours de fonctionnement la verticale d'abscisse Vbo constitue l'axe de symétrie du signal à amplifier dont l'enveloppe, S, a été représentée sur la figure 1.

La figure 2 montre le schéma de principe d'un amplificateur en classe AB. Cet amplificateur comporte un transistor NPN de puissance, T, monté en émetteur commun, avec un circuit d'adaptation d'impédance, 21 entre sa base et l'entrée de l'amplificateur et un autre circuit d'adaptation d'impédance monté entre son collecteur et la sortie de l'amplificateur. La polarisation de la base du transistor est assurée à travers un ensemble constitué par une inductance, L1, un potentiomètre, R, et deux résistances R1, R2; l'inductance L1 relie la base du transistor au curseur du potentiomètre; les extrémités du potentiomètre sont respectivement reliées à une source de tension continue, +V, par la résistance R1 et à la masse par la résistance R2. La polarisation du collecteur du transistor se fait à travers une inductance L2 qui relie ce collecteur à la tension +V ; quant à l'émetteur du transistor il est relié directement à la masse.

Le potentiomètre R permet d'ajuster le courant de repos du transistor en l'absence de signal à l'entrée de l'amplificateur.

La figure 3 est un graphique qui montre la variation de la tension de sortie Vs du montage selon la figure 2 en fonction de la tension d'entrée Ve , le transistor étant polarisé par un faible courant de repos Io (voir figure 1).

Pour régler l'amplificateur selon la figure 2, l'ajustement du potentiomètre R (figure 2) semble la solution la plus évidente et la plus facile. Généralement il existe une position optimale du potentiomètre, correspondant à une valeur de courant de polarisation précise, pour laquelle est obtenue une valeur minimale des produits d'intermodulation provenant de battements entre le signal son et les signaux image, et une valeur minimale de régénération de la bande atténuée. Mais ces valeurs mini-

males ne sont pas satisfaisantes et l'observation du signal image laisse deviner un traînage aux bas niveaux du signal.

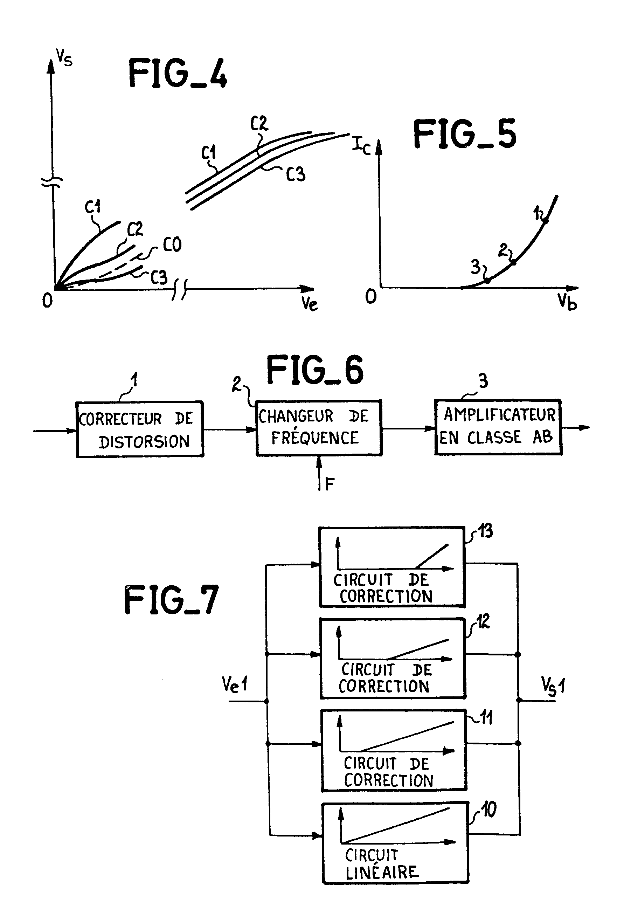

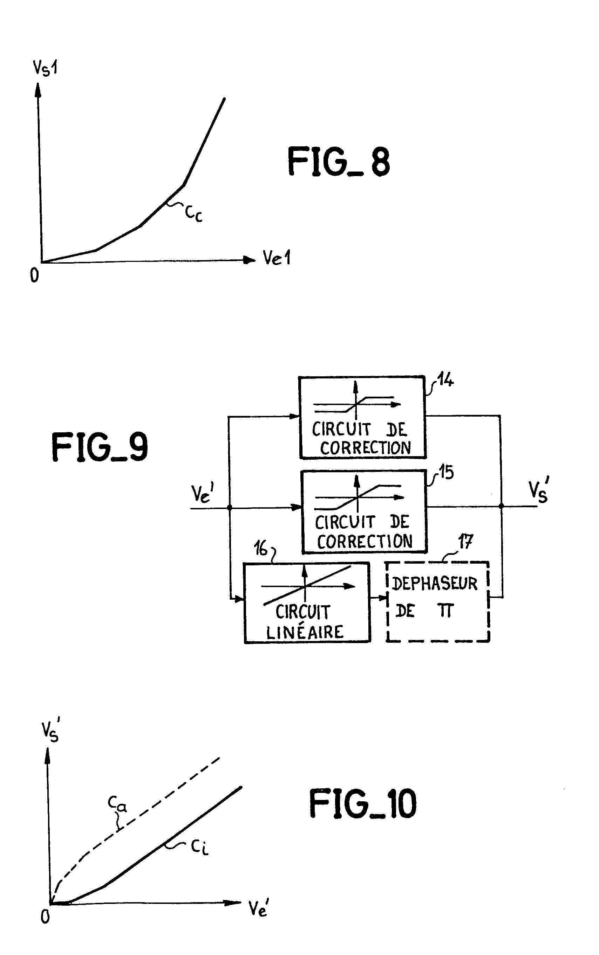

Dans l'étude, commencée à l'aide de la figure 3, du comportement du transistor, le relevé de la courbe au voisinage du zéro nécessite un tel changement d'échelle sur les appareils de mesure, qu'il est négligé. Par association d'idée avec la figure 1, la courbe Cp de la figure 3 est complétée, vers les bas niveaux par une courbure semblable à celle de la courbe C (figure 1) et donc à concavité tournée vers les valeurs croissantes de Vs; c'est la courbe C0 en traits interrompus dont il sera question à l'occasion de la description de la figure 4. Ceci conduit donc, pour essayer d'obtenir une amplification linéaire, à introduire un élément correcteur dont la variation de la tension de sortie, Vs', par rapport à sa tension d'entrée Ve', a l'aspect de la courbe Ca, en traits interrompus, de la figure 10. A titre de preuve, un document de la société RCA, intitulé "The RCA TTG-10 (III) and TTG-12H internally diplexed television Transmitters", présenté dans le cadre de l'exposition du N.A.B. (National Association of Broadcasters) de 1983, montre en page 6 d'une part une courbe de correction qui, pour les petits niveaux, est du type de la courbe Ca susmentionnée et, d'autre part, bien sûr, une courbe de réponse de l'amplificateur à corriger aux petits niveaux qui serait celle indiquée ci-avant, à savoir : concavité tournée vers les valeurs croissantes de Vs. Or l'expérience montre qu'aussi bien pour les amplificateurs en classe AB équipés de transistors que pour ceux équipés de tubes, il n'en est rien : la concavité est tournée vers les valeurs croissantes de Ve et tout au plus, en fonction du point de repos choisi, la courbe peut, passées les premières valeurs, présenter un point d'inflexion et, seulement ensuite, présenter une concavité tournée vers les valeurs croissantes de Vs du moins dans la mesure où Ve et Vs sont des tensions positives. D'une façon plus générale tout ce qui a été dit ou sera dit dans ce texte relativement aux courbures en comparaison avec les valeurs portées par les axes de coordonnées, est valable même si les valeurs considérées sont négatives, à condition de ne tenir compte que des valeurs absolues.

La figure 4 montre un relevé de caractéristiques Vs = f(Ve) pour un amplificateur en classe AB comme indiqué sur la figure 2. Trois courbes, C1, C2, C3, ont été tracées respectivement pour trois points de repos, 1, 2, 3, indiqués sur la courbe de la figure 5 qui donne les variations du courant de repos Ic du collecteur du transistor T en fonction de la polarisation de la base, Vb. De plus, sur la figure 4, a été représentée en traits interrompus la courbe C0 du comportement de l'amplificateur, tel qu'il était supposé se présenter pour les petits niveaux.

Sur la figure 4, l'échelle est dilatée, au voisinage de zéro, sur les deux axes de coordonnés, afin de mieux montrer l'aspect des courbes C0, C1, C2, C3 pour les petits niveaux. Pour les grands niveaux les courbes ont toutes l'aspect déjà observé sur la figure 3. Pour les petits niveaux la pente des courbes Vs = f(Ve) de la figure 4, au voisinage de zéro, est proportionnelle à la pente de la tangente, non représentée, à la courbe de la figure 5 au point de fonctionnement choisi : point 1 pour C1, 2 pour C2 et 3 pour C3.

Les courbes C1 à C3 présentent toutes, au voisinage du zéro, une courbure tournée vers les valeurs croissantes de Ve mais, toujours dans les petits niveaux, les courbes C2 et C3 présentent chacune un point d'inflexion. Ces points d'inflexion rendent difficile la réalisation d'un correcteur ayant la caractéristique inverse; il est donc préférable de choisir une réponse du type de la courbe C1 pour faciliter la correction, c'est-à-dire de choisir une réponse Vs = f(Ve) dont la dérivée soit à variation monotone. Le courant de repos du transistor (ou du tube) en classe AB doit donc être suffisant pour éviter un point d'inflexion sur la courbe Vs = f(Ve), et ce n'est pas parce que les produits d'intermodulation seront plus grands, qu'ils seront plus difficiles à corriger; par contre l'attitude qui consisterait à vouloir les réduire par la polarisation, compliquerait fortement la correction.

Le préjugé qui consistait à vouloir corriger une réponse d'amplificateur du type de la courbe C0 et non du type des courbes C1 à C3 (figure 4), explique que les résultats obtenus étaient imparfaits (dans le cas où, en réalité, la réponse était du type des courbes C2 et C3) voir mauvais (réponse du type C1).

Le correcteur destiné à corriger un amplificateur en classe AB travaillant en radiofréquence, est pratiquement toujours inséré en fréquence intermédiaire dans la chaîne de transmission comportant l'amlificateur; il suffit que le quadripôle de transmission entre le correcteur et l'amplificateur à corriger ait une bande passante suffisante. Ceci est valable non seulement pour les correcteurs connus mais également pour les correcteurs selon la présente invention.

La figure 6 est le schéma de principe d'une chaîne de transmission avec changement de fréquence, dans laquelle un amplificateur et son correcteur de distorsion sont associés pour réaliser une amplification linéaire du signal d'entrée. Le signal à transmettre est appliqué, à travers un correcteur de distorsion, 1, sur l'entrée de signal d'un changeur de fréquence, 2, dont le signal de changement de fréquence est à la fréquence F; le signal en radiofréquence, obtenu à la sortie du changeur de fréquence, est appliqué à l'entrée d'un amplificateur en classe AB, 3. Ce schéma correspond aussi bien à une amplification linéaire en classe AB selon l'art connu que selon la présente invention, et comme il apparaîtra dans ce qui suit, les modifications technologiques nécessaires à la mise en oeuvre de l'invention à partir de l'art connu, sont simples.

Un correcteur de distorsion, comme le correcteur 1 de la figure 6, est formé d'un correcteur de creux destiné à la correction des petits niveaux et, éventuellement si l'amplificateur travaille au voisinage de la saturation, d'un correcteur de crête placé en série avec le correcteur de creux.

Un correcteur de crête utilisé dans une réalisation selon l'invention, est représenté sur la figure 7. Il est composé de quatre circuits en parallèle, dont un, 10, est linéaire et dont les trois autres sont des circuits de correction fonctionnant en classe C. Ces quatre circuits, qui sont à gain et polarisation variables, permettent d'ajuster les seuils et l'efficacité de la correction. La caractéristique résultante "signal de sortie Vs1 par rapport au signal d'entrée Ve1" est représentée sur la figure 8; il s'agit d'une ligne brisée, Cc, qui est une approximation du modèle de courbe à réaliser pour rendre linéaire la réponse de la chaîne de transmission selon la figure 6, dans les niveaux moyens et forts des signaux. Des correcteurs de crête équivalents se trouvent dans les correcteurs de distorsion connus, utilisés pour l'obtention d'une amplification linéaire quelle que soit la classe de fonctionnement.

Un correcteur de creux utilisé dans une réalisation selon l'invention, est représenté sur la figure 9; sa courbe de réponse Vs' = f(Ve') est représentée par la courbe Ci de la figure 10 ; c'est sensiblement la courbe inverse de la courbe Ca représentée en traits interrompus sur la figure 10 et qui, selon le préjugé, était utilisée pour tenter de rendre linéaire la réponse, dans les petits niveaux, de la chaîne de transmission selon la figure 6. Le correcteur de creux selon la figure 9 comporte trois branches connectées en parallèle avec, dans la première, un circuit de correction 14 constitué par un amplificateur linéaire symétrique à seuils d'écrêtage, dans la deuxième, un circuit de correction 15 constitué par un amplificateur linéaire symétrique à seuils d'écrêtage dont les seuils sont différents de ceux du circuit 14, et, dans la troisième, un circuit linéaire 16 en série avec un déphaseur de $\pi$, 17.

La courbe Ca de la figure 10, c'est-à-dire la courbe de correction selon le préjugé, serait obtenue par sommation des signaux de sortie des trois circuits 14 à 16, sans le déphasage de $\pi$ ; ainsi le schéma de la figure 9 correspond, en remplaçant le déphaseur 17 par un court-circuit, à un correcteur de creux selon le préjugé. Pour obtenir la courbe Ci, inverse de la courbe Ca, il ne faut plus faire une somme des signaux de sortie des trois circuits 14 à 16, mais faire une soustraction entre le signal de sortie de la voie linéaire, c'est-à-dire du circuit 16, et les signaux de sortie des circuits de correction 14 et 15. Pour cette soustraction il suffit d'opérer un déphasage de $\pi$ ;c'est le rôle du déphaseur 17 de la figure 9, qui a été représenté par un rectangle à contour en traits interrompus. Cette représentation en traits interrompus du déphaseur 17 vise un double but : d'une part montrer la différence entre un correcteur de creux selon le préjugé et un correcteur de creux où le préjugé a été vaincu, et d'autre part indiquer que la soustraction dont il a été question n'est pas obligatoirement effectuée pu l'adjonction de ce déphaseur; pour obtenir cette soustraction à partir du correcteur de creux selon le préjugé, il est en effet également possible soit de supprimer un étage inverseur dans le circuit de correction 16 s'il en comporte un, soit d'ajouter un déphaseur de $\pi$ en série avec les circuits de correction 14 et 15, soit de supprimer un étage inverseur dans chacun des circuits de correction 14 et 15 s'ils en comportent chacun un.

La présente invention n'est pas limitée à l'exemple décrit, c'est ainsi que les correcteurs de crête peuvent être réalisés selon toute méthode déjà employée dans les correcteurs de distorsion selon le préjugé; il en est de même, à l'inversion de la courbe près (voir figure 10), pour les correcteurs de creux. Quant au correcteur de distorsion, il peut non seulement être disposé en fréquence intermédiaire, comme dans le cas de la figure 6, mais également en radiofréquence, avant ou après l'amplificateur en classe AB.

## Revendications

1.  Amplificateur en classe AB et son correcteur de distorsion, le correcteur (1) comportant un correcteur de creux (14-17), caractérisés en ce que le courant de repos (Io) de l'amplificateur (3) est choisi de manière que la caractéristique Vs = f(Ve) de l'amplificateur (où Ve et Vs sont respectivement les tensions d'entrée et de sortie de l'amplificateur) soit à dérivée à variation monotone pour les faibles niveaux, et en ce que la caractéristique Vs' = f(Ve') du correcteur de creux (où Ve' et Vs' sont respectivement les tensions d'entrée et de sortie du correcteur de creux) présente une concavité tournée vers les valeurs croissantes, au moins en valeur absolue, de Vs'.

2.  Amplificateur et son correcteur de distorsion selon la revendication 1, dont l'amplificateur (3) fonctionne en radiofréquence, caractérisés en ce que le correcteur de distorsion (1) fonctionne en fréquence intermédiaire.

**Claims**

1. Class AB amplifier and distortion corrector thereof, the corrector (1) comprising a corrector of troughs (14-17), characterised in that the zero signal current ($I_0$) of the amplifier (3) is selected such that the characteristic $V_s = f(V_e)$ of the amplifier (where $V_e$ and $V_s$ are the input and output voltages of the amplifier respectively) has a derivative with steady variation for low levels, and in that the characteristic $V_s' = f(V_e')$ of the trough corrector (where $V_e'$ and $V_s'$ are the input and output voltages of the trough corrector respectively) has a concavity directed towards increasing values, at least in absolute value, of $V_s'$.

2. Amplifier and distortion corrector thereof according to claim 1, in which the amplifier (3) operates at radio frequency, characterised in that the distortion corrector (1) operates at intermediate frequency.

**Patentansprüche**

1. AB-Verstärker und seine Verzerrungskorrektureinheit, wobei die Verzerrungskorrektureinheit (1) eine Niedrigpegel-Korrektureinheit (14-17) enthält, dadurch gekennzeichnet, daß der Ruhestrom (Io) des Verstärkers (3) so gewählt ist, daß die Kennlinie Vs = f(Ve) des Verstärkers (wobei Ve die Eingangsspannung und Vs die Ausgangsspannung des Verstärkers ist) für niedrige Pegel eine monotone Ableitung hat, und daß die Kennlinie Vs' = f(Ve') der Niedrigpegel-Korrektureinheit (wobei Ve' die Eingangsspannung und Vs' die Ausgangsspannung der Niedrigpegel-Korrektureinheit ist) wenigstens hinsichtlich des Absolutwerts von Vs' gegen zunehmende Werte hin konkav verläuft.

2. Verstärker und seine Verzerrungskorrektureinheit gemäß Anspruch 1, wobei der Verstärker (3) im Hochfrequenzbereich arbeitet, dadurch gekennzeichnet, daß die Verzerrungskorrektureinheit (1) im Zwischenfrequenzbereich arbeitet.

## FIG_1

## FIG_2

## FIG_3

## FIG_4

## FIG_5

## FIG_6

| CORRECTEUR DE DISTORSION | CHANGEUR DE FRÉQUENCE | AMPLIFICATEUR EN CLASSE AB |

## FIG_7

CIRCUIT DE CORRECTION

CIRCUIT DE CORRECTION

CIRCUIT DE CORRECTION

CIRCUIT LINÉAIRE

7

FIG_8

$V_S1$

$C_c$

$V_e1$

0

FIG_9

$V_e'$

CIRCUIT DE CORRECTION — 14

CIRCUIT DE CORRECTION — 15

16) CIRCUIT LINÉAIRE

17 DEPHASEUR DE π

$V_S'$

FIG_10

$V_S'$

$C_a$

$C_i$

$V_e'$

0

8